# EUROPÄISCHE PATENTSCHRIFT

(11) **EP 4 121 788 B1**
(45) Veröffentlichungstag und Bekanntmachung des Hinweises auf die Patenterteilung: **01.05.2024**
(21) Anmeldenummer: 21717764.1
(22) Anmeldetag: 18.03.2021
(51) Int. Cl.: G01R 31/28, G01R 35/00, G01R 1/073

(54) **TESTVORRICHTUNG FÜR PRÜFKARTEN**
TEST APPARATUS FOR TEST CARDS
DISPOSITIF DE TEST POUR APPAREIL D'ESSAI

(30) Priorität: 18.03.2020 DE 202020101484 U
(43) Veröffentlichungstag der Anmeldung: 25.01.2023
(73) Patentinhaber: Feinmetall GmbH, 71083 Herrenberg (DE)
(72) Erfinder: MOLITOR, Carsten, 71159 Mötzingen (DE); MARKOVSKI, Aleksandar, 71116 Gärtringen (DE); SEEFELDT, Helmut, 71106 Magstadt (DE)
(74) Vertreter: Clarenbach, Carl-Philipp
(86) Internationale Anmeldenummer: PCT/EP2021/056995
(87) Internationale Veröffentlichungsnummer: WO 2021/185985

(56) Entgegenhaltungen:
- DE-T5-112004 000 480
- US-A- 4 812 754
- US-A1- 2019 339 323

## Beschreibung

Die Erfindung betrifft eine Testvorrichtung für Prüfkarten, mit einer Aufnahmeeinrichtung zum Halten zumindest einer zu prüfenden Prüfkarte, mit wenigstens einer Kontakteinrichtung zum elektrischen Berührungskontaktieren von elektrisch leitfähigen Kontaktstellen der zumindest einen Prüfkarte in der Aufnahmeeinrichtung, wobei die Kontakteinrichtung vertikal oberhalb der Aufnahmeeinrichtung zur Berührungskontaktierung anordenbar oder angeordnet ist, und mit einer Stelleinrichtung, die dazu ausgebildet ist, die Kontakteinrichtung und die Aufnahmeeinrichtung zur Herstellung der Berührungskontaktierung relativ zueinander zu verlagern.

Testvorrichtungen der eingangs genannten Art sind aus dem Stand der Technik bereits bekannt. Prüfkarten werden dazu eingesetzt, Prüflinge elektrisch zu kontaktieren, um deren Funktionsfähigkeit zu prüfen. Dazu weisen Prüfkarten in der Regel eine Vielzahl von elektrisch leitfähigen Kontaktelementen auf, die einendig dem Prüfling zugeordnet sind und anderendig mit beispielsweise einem Kontaktabstandstransformer und einer Leiterplatte mit einem oder mehreren elektronischen Bauteilen zusammenwirken. Derartige Prüfkarten werden für eine Vielzahl von Prüfvorgängen eingesetzt, um in kurzer Zeit eine hohe Anzahl von Prüflingen zu testen. Um sicherzustellen, dass die Prüfkarten keine Fehlmessungen vornehmen, sind auch die Prüfkarten auf ihre Funktionsfähigkeit zu testen. Bisherige Testvorrichtungen weisen dazu eine Aufnahmeeinrichtung auf, in welcher eine oder mehrere Prüfkarten angeordnet werden können. Oberhalb der Aufnahmeeinrichtung wird eine Kontakteinrichtung platziert, die zum Berührungskontaktieren der Prüfkarte ausgebildet ist. Zum Durchführen eines Testvorgangs wird beispielsweise die Kontakteinrichtung auf die Aufnahmeeinrichtung geklappt und anschließend oder vorab die Kontakteinrichtung mit einer Testeinrichtung, die mit der Kontakteinrichtung elektrisch verbunden ist, um einen Test an der jeweiligen Prüfkarte durchzuführen, verbunden. Für einen Austausch der zu prüfenden Prüfkarte muss die gesamte Kontakteinrichtung wieder entfernt werden, wodurch in einer gegebenen Zeit nur eine kleine Anzahl von Prüfkarten getestet werden kann.

Aus der Offenlegungsschrift US 4 812 754 A ist bereits eine Testvorrichtung bekannt, bei welcher eine Berührungskontakt eines Prüflings durch Verschwenken und Verschieben eines ersten Elements relativ zu einem zweiten Element erfolgt, wobei die beiden Elemente jeweils eine Schublade zur Aufnahme einer Kontaktvorrichtung aufweisen. Die Offenlegungsschrift US 2019/339323 A1 beschreibt eine Fördereinrichtung zum Hindurchfördern von Prüflingen durch eine Prüfvorrichtung. Aus der Offenlegungsschrift DE 11 2004 000 480 T5 ist des Weiteren eine Testvorrichtung mit einem Schubladenelement zur Aufnahme von Prüfkarten bekannt.

Der Erfindung liegt die Aufgabe zugrunde, eine verbesserte Testvorrichtung zu schaffen, welche eine hohe Anzahl von Tests durchführen kann, indem der Austausch der Prüfkarten vereinfacht und optional automatisiert wird.

Diese Aufgabe wird durch eine Testvorrichtung mit den Merkmalen des Anspruchs 1 gelöst. Erfindungsgemäß ist hierzu vorgesehen, dass die Aufnahmeeinrichtung durch die Stelleinrichtung von einer vertikal unterhalb der Kontakteinrichtung befindlichen Testposition in eine seitlich von der Kontakteinrichtung beabstandete Be- und Entladeposition und zurück verlagerbar ist. Die Erfindung sieht also vor, dass die Aufnahmeeinrichtung seitlich beziehungsweise horizontal verlagerbar ist. Dadurch kann die Aufnahmeeinrichtung einfach unter der Kontakteinrichtung hervorgezogen werden, um mit einer oder mehreren Prüfkarten beladen und anschließend wieder zurück unter die Kontakteinrichtung geschoben zu werden. Durch dieses seitliche Verschieben der Aufnahmeeinrichtung ist ein einfacher Austausch der Prüfkarten möglich, bei welchem insbesondere auf ein Demontieren der Kontakteinrichtung verzichtet werden kann. Die Be- und Entladeposition zeichnet sich insbesondere dadurch aus, dass die Aufnahmeeinrichtung derart weit von der Kontakteinrichtung entfernt ist, dass ein oder mehrere Prüfkarten hinderungsfrei von oben in die Aufnahmeeinrichtung eingesetzt werden können.

Erfindungsgemäß weist die Testvorrichtung einen Rahmen auf, an welchem die Aufnahmeeinrichtung und die Kontakteinrichtung gelagert sind. Durch den Rahmen sind die Aufnahmeeinrichtung und die Kontakteinrichtung sicher aneinander und zueinander gehalten und können wie gewünscht verlagert werden.

Erfindungsgemäß ist die Aufnahmeeinrichtung als horizontal verschiebbare Schublade an dem Rahmen gelagert. Dazu weisen der Rahmen oder die Aufnahmeeinrichtung beispielsweise Führungsschienen auf, entlang welcher die Aufnahmeeinrichtung beziehungsweise die Schublade verschiebbar ist. Durch die Führungsschienen wird eine präzise und genaue Führung von der Be- und Entladeposition in die Kontaktposition beziehungsweise Testposition gewährleistet, sodass eine vorteilhafte Ausrichtung der einen oder der mehreren Prüfkarten bezüglich der Kontakteinrichtung in der Testposition gewährleistet ist. Vorzugsweise weist die Aufnahmeeinrichtung dabei Zentriermittel zum Ausrichten und Anordnen der zumindest einen Prüfkarte auf, um die sichere Zuordnung der Kontakteinrichtung zu den elektrischen Kontaktstellen der zu testenden Prüfkarte zu gewährleisten.

Weiterhin ist erfindungsgemäß vorgesehen, dass die Kontakteinrichtung durch die Stelleinrichtung vertikal zwischen einer Berührungskontaktposition und einer Freigabeposition verschiebbar gelagert ist. In der Berührungskontaktposition ist die Kontakteinrichtung derart weit in Richtung der Aufnahmeeinrichtung und der darin befindlichen Prüfkarte abgesenkt, dass die Kontaktstellen der Prüfkarte durch die Kontakteinrichtung berührungskontaktiert werden. In der Freigabeposition ist die Kontakteinrichtung derart weit von der Prüfkarte und der Aufnahmeeinrichtung nach oben verlagert, dass die Aufnahmeeinrichtung aus der Testposition in die Be- und Entladeposition verschoben werden kann, ohne dass dabei Reibung zwischen der Kontakteinrichtung und der Aufnahmeeinrichtung, insbesondere zwischen der Prüfkarte und der Kontakteinrichtung, auftreten kann.

Erfindungsgemäß weist die Stelleinrichtung zumindest einen ersten ansteuerbaren Aktuator zum Verschieben der Aufnahmeeinrichtung auf. Dadurch ist eine automatisierte Verlagerung der Aufnahmeeinrichtung von der Be- und Entladeposition in die Festposition und andersherum ermöglicht, sodass ein zumindest teilautomatisierter Betrieb oder ein vollautomatisierter Betrieb der Testvorrichtung möglich ist.

Weiterhin ist erfindungsgemäß vorgesehen, dass die Stelleinrichtung zumindest einen zweiten ansteuerbaren Aktuator zum Verlagern der Kontakteinrichtung aufweist. Damit ist auch ein automatisiertes Verlagern der Kontakteinrichtung von der Berührungskontaktposition in die Freigabeposition und andersherum ermöglicht. Durch die teil- oder vollautomatisierte Ausbildung der Testvorrichtung wird die Anzahl der Schritte, die ein menschlicher Benutzer oder Bediener der Testvorrichtung selbst durchführen muss, minimiert, wodurch die Effizienz eines Testvorgangs erhöht und die Anzahl der durchgeführten Tests maximiert werden kann. Darüber hinaus wird eine Fehlbedienung der Testvorrichtung in vorteilhafter Art und Weise vermieden. Optional ist die Testvorrichtung derart vollautomatisch ausgebildet, dass der Benutzer lediglich die jeweilige zu testende Prüfkarte in der Aufnahmeeinrichtung anordnen und aus dieser nach erfolgtem Prüfvorgang wieder herausholen muss. Gemäß einer optionalen Ausführungsform weist die Testvorrichtung außerdem eine Be- und Entladeeinrichtung auf, die eine oder mehrere Prüfkarten vollautomatisch in der Aufnahmeeinrichtung platziert oder aus dieser entfernt, sodass ein Einsatz der Testvorrichtung auch ohne manuelle Unterstützung eines Bedieners möglich ist.

Besonders bevorzugt weisen der erste Aktuator und/oder der zweite Aktuator jeweils zumindest einen Elektromotor auf. Dieser ist bauraumsparend in die Testvorrichtung integrierbar und kann präzise angesteuert werden, um die gewünschte Bewegung der Kontakteinrichtung und/oder der Aufnahmeeinrichtung zu gewährleisten. Alternativ oder zusätzlich weisen der erste und/oder der zweite Aktuator vorzugsweise einen Hydraulikmotor, Pneumatikmotor, Magnetmotor oder dergleichen auf.

Erfindungsgemäß ist der zweite Aktuator mit wenigstens einem Schieber gekoppelt, der insbesondere parallel zur Schieberichtung der Aufnahmeeinrichtung verschiebbar ist und eine Kulissenführung aufweist, die mit einem Mitnahmevorsprung der Kontakteinrichtung zum vertikalen Verlagern der Kontakteinrichtung zusammenwirkt.

Durch den verlagerbaren Schieber wird erreicht, dass zum einen eine Kraftübersetzung von dem Aktuator beziehungsweise dem Elektromotor auf die Kontakteinrichtung erfolgt, und dass zum anderen eine eindeutige Führung der Kontakteinrichtung durch den Schieber ermöglicht ist. Durch die einfache Ausbildung mit Kulissenführung und Mitnahmevorsprung ist gewährleistet, dass die Vertikalposition der Kontakteinrichtung mit der Schiebeposition des Schiebers jederzeit korrespondiert.

Erfindungsgemäß weist die Kulissenführung eine schräge Anlauffläche auf, durch welche der Mitnahmevorsprung bei einer Verschiebung des Schiebers angehoben oder abgesenkt wird.

Dabei ist der Kontakteinrichtung bevorzugt zumindest ein Federelement zugeordnet, welches die Kontakteinrichtung mit dem Mitnahmevorsprung gegen die Kulissenführung drängt. Dadurch ist sichergestellt, dass die Kontakteinrichtung mit dem Mitnahmevorsprung stets an der Kulissenführung, insbesondere an der Anbaufläche, anliegt, um eine Zwangsführung der Kontakteinrichtung in Abhängigkeit der Verschiebung des Schiebers zu gewährleisten. Dadurch ist eine präzise und insbesondere eindeutige Stellung der Kontakteinrichtung in Abhängigkeit von der Schiebeposition des Schiebers erreichbar.

Weiterhin ist bevorzugt vorgesehen, dass die Kulissenführung an zumindest einem Ende einen Fanghaken für den Mitnahmevorsprung aufweist. Durch den Fanghaken wird gewährleistet, dass der Mitnahmevorsprung die Kulissenführung nicht verlassen kann. Stattdessen ist der Mitnahmevorsprung formschlüssig durch den Fanghaken an der Kulissenführung gehalten. Insbesondere weist die Kulissenführung an beiden Führungsenden jeweils einen Fanghaken auf, sodass der Mitnahmevorsprung nicht von der Kulissenführung lösbar ist.

Weiterhin ist vorteilhaft vorgesehen, dass die Kontakteinrichtung durch zumindest drei Führungsbolzen vertikal verschiebbar gelagert ist. Insbesondere erstrecken sich die Führungsbolzen durch Führungsöffnungen der Kontakteinrichtung, um eine eindeutige Lagerung und Führung der Kontakteinrichtung zu gewährleisten.

Besonders bevorzugt ist an jedem der Führungsbolzen jeweils ein Federelement angeordnet, das die Kontakteinrichtung gegen die Kulissenführung drängt. Dadurch, dass jedem der Führungsbolzen ein Federelement zugeordnet ist, ist eine gleichmäßige Kraftbeaufschlagung der Kontakteinrichtung in Richtung der Kulissenführung gewährleistet, sodass auch Schiefstellungen der Kontakteinrichtung beim Betätigen des zweiten Aktuators vermieden werden. Besonders bevorzugt ist die Kontakteinrichtung durch vier Führungsbolzen verschiebbar gelagert, die insbesondere an den Außenecken der insbesondere rechteckförmigen Aufnahmeeinrichtung beziehungsweise Kontakteinrichtung angeordnet sind. Insbesondere werden die Führungsbolzen von dem zuvor genannten Rahmen gehalten.

Gemäß einer weiteren Ausführungsform der Erfindung weist der zweite Aktuator vorzugsweise eine mit der Tragstruktur koppelbare Hebeeinrichtung auf. In diesem Fall kann auf die zuvor genannte Kulissenführung an dem Schieber verzichtet werden. Durch die Hebeeinrichtung ist die in der Aufnahmeeinrichtung angeordnete Tragstruktur anhebbar, sodass nicht die gesamte Aufnahmeeinrichtung, sondern nur die Tragstruktur vertikal verlagert wird, um der Kontakteinrichtung zur Herstellung der Berührungskontaktierung zugeführt zu werden. in Diesem Fall kann auf eine vertikale Verlagerung der Kontakteinrichtung insgesamt verzichtet werden, wodurch die Steuereinrichtung lediglich der Aufnahmeeinrichtung zugeordnet ist. Dadurch wird die Testvorrichtung insgesamt noch kompakter gestaltet.

Besonders bevorzugt weist die Aufnahmeeinrichtung eine austauschbare Tragstruktur auf, die dazu ausgebildet ist, eine oder mehrere Prüfkarten zu halten. Insbesondere weist die Testvorrichtung eine Vielzahl von Tragstrukturen auf, die wahlweise in der Aufnahmeeinrichtung anordenbar sind. Die Tragstrukturen sind dabei insbesondere für unterschiedliche Prüfkarten und/oder für unterschiedliche Anzahlen von Prüfkarten, die gleichzeitig getestet werden sollen, ausgebildet/angepasst, sodass je nach durchzuführendem Test zunächst die passende Tragstruktur in die Aufnahmeeinrichtung eingesetzt wird. Die Tragstrukturen weisen dabei optional Mitnahmevorsprünge auf, die mit der zuvor genannten Hebeeinrichtung zusammenwirken können, sodass die Tragstrukturen unabhängig von der Aufnahmeeinrichtung vertikal der Kontakteinrichtung zugeführt werden können.

Vorzugsweise weist die Aufnahmeeinrichtung einen Tragrahmen auf, auf welchem die Tragstruktur ablegbar ist. Insbesondere der Tragrahmen und die Tragstruktur derart ausgebildet, dass eine eindeutige Ausrichtung und Anordnung der Tragstruktur an den Tragrahmen gewährleistet ist, der eine Fehlmontage der Tragstruktur vermeidet. Dadurch ist ein sicheres Zuführen der Prüfkarten zu der Kontakteinrichtung zum Berührungskontaktieren der gewünschten Kontaktstellen gewährleistet.

Besonders bevorzugt ist die Tragstruktur wannenförmig ausgebildet, sodass sie insbesondere einen geschlossenen Boden aufweist. Auf dem geschlossenen Boden können beispielsweise eine oder mehrere Prüfkarten aufgestellt werden, oder der geschlossene Boden dient insbesondere dazu, Schmutzpartikel oder dergleichen aufzufangen.

Besonders bevorzugt weist der Rahmen der Stelleinrichtung geschlossene Seitenwände auf, wodurch erreicht wird, dass während der Durchführung eines Tests und auch davor oder danach das Eindringen von Schmutzpartikeln, Feuchtigkeit oder dergleichen in die Testvorrichtung hinein erschwert oder verhindert wird.

Besonders bevorzugt ist eine Testeinrichtung vorhanden, die mit der Kontakteinrichtung elektrisch verbunden oder verbindbar ist. Mittels der Testeinrichtung wird die Kontakteinrichtung betrieben, um die gewünschten Tests an der jeweiligen Prüfkarte durchzuführen.

Besonders bevorzugt ist die Kontakteinrichtung zur Aufnahme eines oder mehrerer unterschiedlicher Kontaktmodule zur Berührungskontaktierung der zumindest einen Prüfkarte ausgebildet. Dadurch kann die Kontakteinrichtung auf einfache Art und Weise an den durchzuführenden Testvorgang angepasst werden. Insbesondere weisen die Kontaktmodule Steckverbindungen auf, die mit der Testeinrichtung verbindbar sind, um eine einfachen Austausch einzelner Module zu ermöglichen.

Im Folgenden soll die Erfindung anhand der Zeichnungen näher erläutert werden. Dazu zeigen
- Figur 1: eine vorteilhafte Testeinrichtung gemäß einem ersten Betriebszustand,
- Figur 2: die Testvorrichtung in einem zweiten Betriebszustand,
- Figur 3: die Testvorrichtung in einem dritten Betriebszustand,
- Figur 4: die Testvorrichtung in einem vierten Betriebszustand,
- Figur 5: die Testvorrichtung in einem fünften Betriebszustand,
- Figur 6: die Testvorrichtung in einem sechsten Betriebszustand, jeweils in einer perspektivischen Darstellung, und
- Figur 7: eine optionale Weiterbildung der Testvorrichtung in einer vereinfachten Schnittdarstellung.

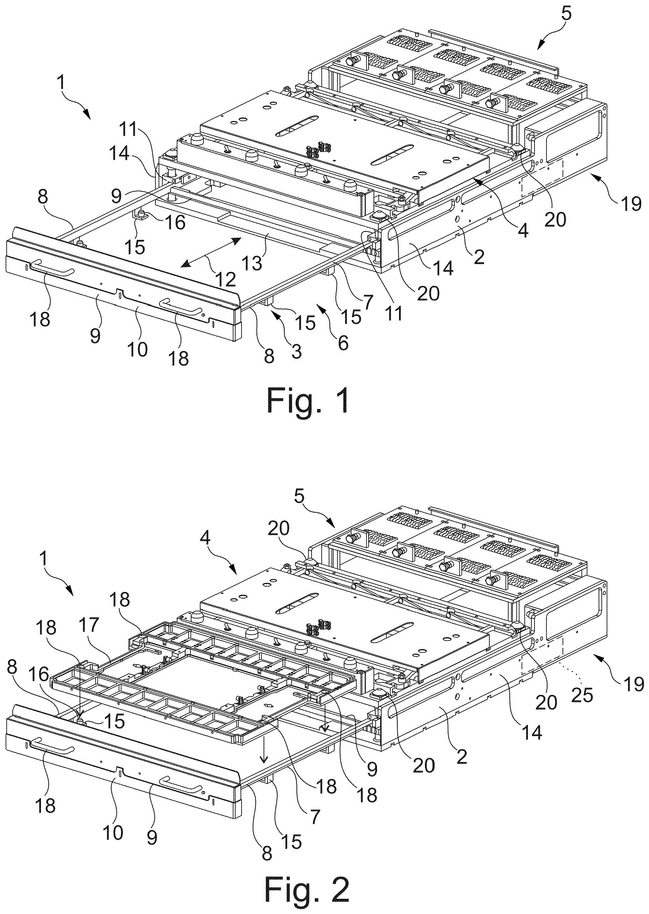

Figur 1 zeigt in einer vereinfachten perspektivischen Darstellung eine vorteilhafte Testvorrichtung 1 für Prüfkarten. Mittels der Testvorrichtung 1 können Prüfkarten, die zum Testen elektrischer/elektronischer Prüflinge eingesetzt werden, auf ihre eigene Funktionsfähigkeit geprüft werden.

Die Testvorrichtung 1 weist dazu einen Rahmen 2 auf, an welchem eine Aufnahmeeinrichtung 3 und eine Kontakteinrichtung 4 angeordnet sind. Des Weiteren ist an dem Rahmen 2 eine Prüfeinrichtung 5 angeordnet, die elektrisch mit der Kontaktiervorrichtung 4 verbunden oder verbindbar ist und dazu ausgebildet ist, durch die Kontakteinrichtung 4 eine oder mehrere Prüfkarten, die in der Aufnahmeeinrichtung 3 angeordnet sind, wie im Folgenden näher erläutert werden soll, auf ihre Funktionsfähigkeit zu testen. Dabei ist die Kontakteinrichtung 4 dazu ausgebildet, die eine oder die mehreren Prüfkarten durch Berührungskontaktierung elektrisch zu kontaktieren und dadurch die Verbindung zu der Prüfeinrichtung 5 herzustellen.

Die Aufnahmeeinrichtung 3 ist als Schublade 6 ausgebildet. Dabei weist die Aufnahmeeinrichtung 3 einen Tragrahmen 7 auf, der zumindest zwei parallel zueinander ausgerichtet und beabstandet zueinander angeordnete Längsträger 8 aufweist, die durch mindestens zwei Querträger 9 miteinander verbunden sind, wobei einer der Querträger 9 ein Schließelement 10 aufweist. Die Längsträger 8 sind vorteilhafterweise in jeweils einer Führungsschiene 11, die in dem Rahmen 2 angeordnet ist, horizontal verschiebbar gelagert, wie durch einen Doppelpfeil 12 in Figur 1 angezeigt. Der Rahmen 2 weist dabei eine Öffnung 13 auf, durch welche die Längsträger 8 in die in dem Rahmen 2 angeordneten Führungsschienen 11 geführt sind. Die Führungsschienen 11 liegen dabei beispielsweise an geschlossenen Seitenwänden 14 des Rahmens 2 innerhalb des Rahmens 2 an. Das Schließelement 10 ist derart groß ausgebildet, dass es die Öffnung 13 vollständig überdeckt, wenn die Schublade 6 vollständig in den Rahmen 2 eingeschoben ist. An der Tragstruktur 7 sind des Weiteren L-förmige Halter 15 angeordnet, die jeweils einen Zentierbolzen 16 aufweisen. Die Halter 15 ragen mit einem ersten Schenkel vertikal von den Längsträgern 8 nach unten und mit dem zweiten, insbesondere senkrecht zu dem ersten Schenkel ausgerichteten weiteren Schenkel, der den Zentrierbolzen 16 trägt, seitlich in Richtung des auf den an dem gegenüberliegenden Längsträger 8 angeordneten Halter 15 vor, sodass die zweiten Schenkel im Wesentlichen horizontal ausgerichtet sind und zwischen den Längsträgern, in einer Draufsicht auf die Aufnahmevorrichtung 3, liegen.

Der Tragrahmen 7 ist dazu ausgebildet, eine austauschbare Tragstruktur 17 aufzunehmen und auszurichten. Figur 2 zeigt dazu in einem weiteren Betriebszustand der Testvorrichtung 1 nunmehr zusätzlich eine wannenförmige Tragstruktur 17, die der Aufnahmeeinrichtung 3 vertikal von oben, wie durch Pfeile in Figur 2, zugeführt wird. Die Tragstruktur 17 ist dabei als Aufnahmewanne ausgebildet, die zur Halterung und Ausrichtung einer oder mehrerer Prüfkarten ausgebildet ist. Dabei weist die Testeinrichtung 1 bevorzugt eine Vielzahl derartiger Tragstrukturen 17 auf, die austauschbar ausgebildet sind und somit jeweils an der Aufnahmeeinrichtung 3 anordenbar sind, um unterschiedlich ausgebildete und/oder eine unterschiedliche Anzahl von Prüfkarten aufnehmen zu können. Mithilfe der austauschbaren Tragstruktur 17 ist somit eine einfache Anpassung der Testeinrichtung 1 an unterschiedliche zu prüfende Prüfkarten möglich.

Die Tragstruktur 17 weist insbesondere für jeden der Zentrierbolzen 16 eine entsprechende Zentrieraufnahme 18 auf, in welche die Zentrierbolzen 16 eingeführt werden, wenn die Tragstruktur 17 auf die Aufnahmeeinrichtung 3 beziehungsweise den Tragrahmen 7 aufgesetzt wird, wie in Figur 2 gezeigt. Dadurch wird die Tragstruktur 17 vorteilhaft an dem Tragrahmen 7 ausgerichtet und an der Aufnahmeeinrichtung 3 arretiert.

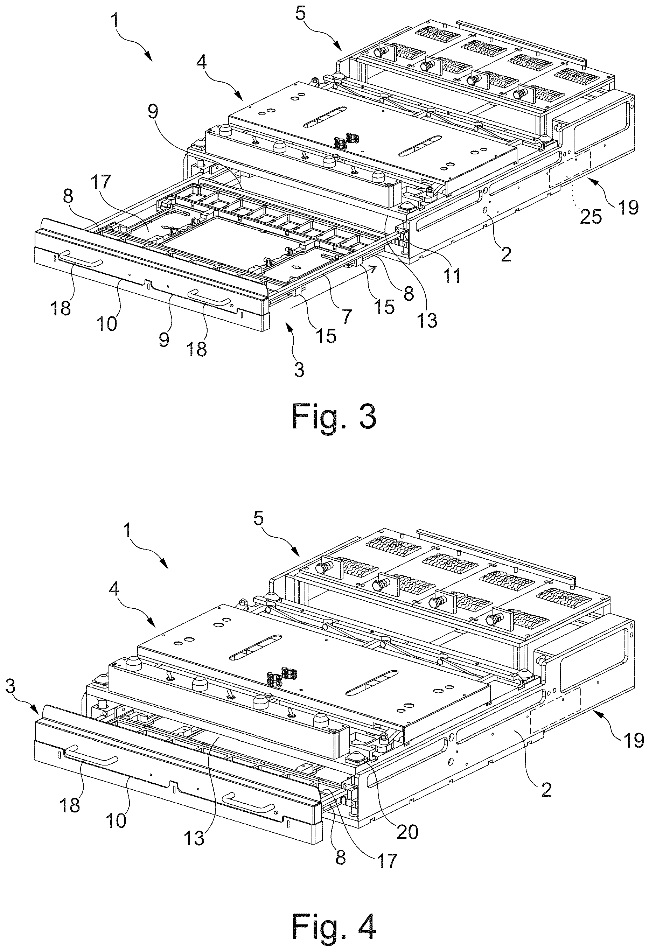

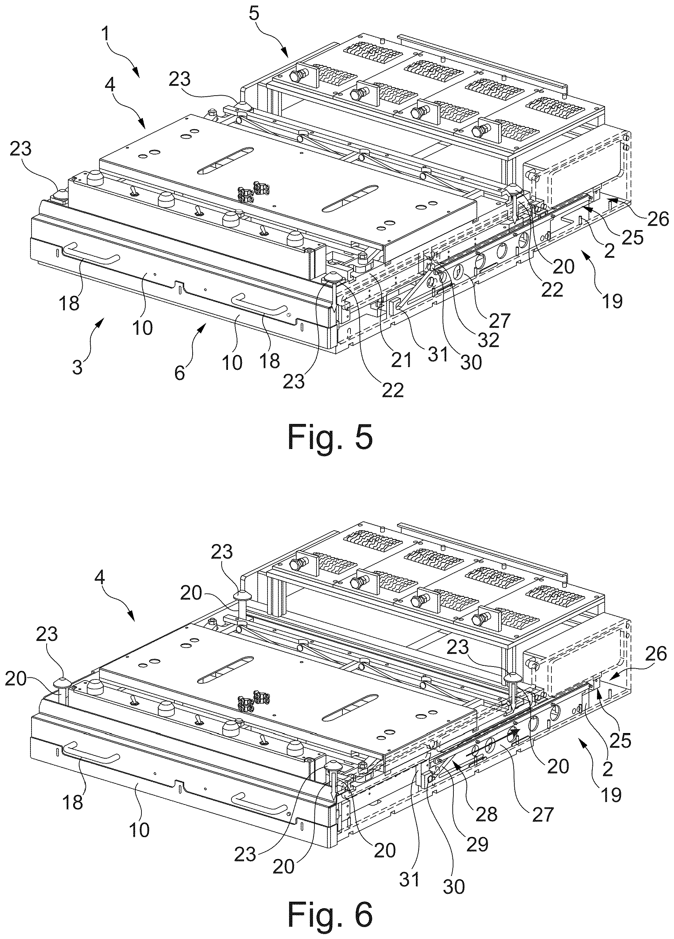

Figur 3 zeigt die vollständig in den Tragrahmen 7 eingesetzte Tragstruktur 17. Sobald die Tragstruktur 17 an dem Tragrahmen 7 angeordnet und gehalten ist, wird die Aufnahmeeinrichtung 3 gemäß dem in Figur 3 eingezeichneten Pfeil mithilfe der in den Führungsschienen 11 liegenden Längsträger 8 horizontal in den Rahmen 2 durch die Öffnung 13 hineingeschoben, wie in einem weiteren Schritt in Figur 4 gezeigt. Damit wird die Aufnahmeeinrichtung 3 von einer Be- und Entladeposition, wie sie in Figuren 1 bis 3 gezeigt ist, in eine Testposition verschoben, in welcher die Tragstruktur 17 direkt vertikal unterhalb der Kontakteinrichtung 4 angeordnet ist, wie in Figur 5 gezeigt. Figur 5 zeigt die vollständig eingefahrene Aufnahmeeinrichtung 3 beziehungsweise Schublade 6, die mit dem Schließelement 10 nunmehr die Öffnung 13 vollständig verschließt. Das Schließelement 10 weist optional einen oder mehrere Haltegriffe 18 auf, mittels welcher ein Benutzer die Aufnahmeeinrichtung 3 manuell von der Be- und Entladeposition in die Testposition oder andersherum verschieben kann. Alternativ oder zusätzlich weist die Testvorrichtung 1 eine Stelleinrichtung 19 auf, die zumindest einen ersten Aktuator 25 aufweist, der einen Elektromotor umfasst, der mit der Aufnahmeeinrichtung 3 derart wirkverbunden ist, dass durch Ansteuerung des Elektromotors des ersten Aktuators 25 die Schublade 6 beziehungsweise die Aufnahmeeinrichtung 3 automatisiert von der Be- und Entladeposition in die Testposition und andersherum bewegt wird.

Sobald die Aufnahmeeinrichtung 3 beziehungsweise die Schublade 6 die Testposition erreicht hat, in welcher sie direkt unterhalb, also vertikal unterhalb der Kontakteinrichtung 4 liegt, wie in Figur 6 gezeigt, wird die Kontakteinrichtung zur Berührungskontaktierung der in der Aufnahmeeinrichtung 3 befindlichen Prüfkarte oder Prüfkarten vertikal in Richtung der Prüfkarte nach unten verlagert, wie durch Pfeile in Figur 6 gezeigt. Die Kontakteinrichtung ist dazu an dem Rahmen 2 vertikal verschiebbar gelagert. Dazu sind an dem Rahmen gemäß dem vorliegenden Ausführungsbeispiel vier Führungsbolzen 20 angeordnet, die vertikal in ihrer Längserstreckung ausgerichtet und parallel zueinander angeordnet sind. Dabei sind die Führungsbolzen 20 jeweils an den Außenecken der Kontakteinrichtung 4 in dem Rahmen 2 angeordnet. Die Kontakteinrichtung 4 weist vorliegend eine Tragplatte 21 auf, in welcher für jeden der Führungsbolzen jeweils eine Führungsöffnung 22 ausgebildet ist. Somit ist die Tragplatte 21 entlang der Führungsbolzen vertikal in dem Rahmen 2 verschiebbar gelagert. Die Führungsbolzen 20 weisen vorteilhafterweise an ihrem freien von der Kontakteinrichtung 3 abgewandten Ende jeweils einen Kopf 23 mit einem Außendurchmesser auf, der größer ist als der Durchmesser der Führungsöffnungen 22, sodass die Trägerplatte 3 dauerhaft an den Führungsbolzen 20 gehalten ist. Optional sind zwischen dem jeweiligen Kopf und der Trägerplatte 21 jeweils ein Federelement, insbesondere eine koaxial zu dem jeweiligen Führungsbolzen 20 angeordnete Schraubenfeder, angeordnet, welche die Trägerplatte 21 nach unten in Richtung der Aufnahmeeinrichtung 3 drängt, wie in Figur 5 durch Pfeile angezeigt.

Zum Verlagern der Kontakteinrichtung 4 weist die Stelleinrichtung 19 einen zweiten Aktuator 26 auf, der insbesondere einen Elektromotor zum Antrieb aufweist. Der Aktuator 26 weist weiterhin an jeder Seitenwand 14 des Randes 2 angeordnet jeweils einen Schieber 27 auf, der parallel zur Seitenwand 14 ausgerichtet und verschiebbar gelagert ist. Der jeweilige Schieber 27 ist mit dem Elektromotor oder mit jeweils einem Elektromotor des Aktuators 26 wirkverbunden, sodass durch Ansteuern des jeweiligen Elektromotors der jeweilige Schieber 27 horizontal und insbesondere parallel zu den Seitenwänden 14 und damit auch parallel zu der jeweiligen Führungsschiene 11 verschoben wird.

Der jeweilige Schieber 27 weist an seinem der Öffnung 13 zugewandten Ende eine Kulissenführung 28 auf. Figuren 5 und 6 zeigen dazu eine Seitenwand 14 durchsichtig, sodass das Innenleben der Testvorrichtung 1 in diesem Bereich erkennbar ist.

Die Kulissenführung 28 weist eine Anlaufschräge 29 auf, die eine Steigung derart aufweist, dass die Höhe des Schiebers beziehungsweise der Kulissenführung 28 von dem freien Ende aus gesehen von der Öffnung 13 weg zunimmt. Auf der Kulissenführung 28 ist ein Mitnahmevorsprung 30 der Kontakteinrichtung 4, insbesondere der Trägerplatte 21, geführt. Der Mitnahmevorsprung 30 liegt dabei auf der Anlaufschräge 29 auf. Die Kulissenführung 28 weist außerdem an jedem Ende der Anlaufschräge 29 einen Fanghaken 31, 32 auf, der dazu ausgebildet ist, den Mitnahmevorsprung 30 formschlüssig aufzunehmen und an einer Weiterbewegung zu hindern. Dadurch kann der Mitnahmevorsprung 30 die Kulissenführung 28 nicht verlassen und der Aktuator 25 ist vorteilhaft mit der Kontakteinrichtung 4 verbunden.

In dem in Figur 5 gezeigten Ausgangszustand liegt der Mitnahmevorsprung 30 in dem oberen Fanghaken 32. Die Trägerplatte 21 liegt der gezeigten Freigabeposition somit auf dem Schieber 27 beziehungsweise auf der Anlaufschräge 29 am oberen Ende in dem Fanghaken 32 auf und kann nicht nach unten fallen. Durch Ansteuern des Aktuators 25 wird nunmehr der Schieber 27, wie durch einen horizontalen Pfeil in Figuren 5 und 6 gezeigt, von der Öffnung 13 weg nach hinten in Richtung der Steuereinrichtung 5 verschoben, sodass der Mitnahmevorsprung 30 auf der Anlaufschräge 29 nach unten gleitet, wodurch die Trägerplatte 21 nach unten und die Kontakteinrichtung 4 insgesamt auf die Aufnahmeeinrichtung 3 beziehungsweise die darin befindlichen Prüfkarten zu bewegt wird, um diese in der abgesenkten Berührungskontaktposition durch Berührung elektrisch zu kontaktieren. Der Schieber 27 kann maximal derart weit nach hinten verfahren werden, bis der Mitnahmevorsprung 30 in dem unteren Fanghaken 31 gefangen ist. Durch den Aktuator 26 ist somit eine sichere und einfache vertikale Verlagerung der Kontakteinrichtung 4 ermöglicht. Durch die vorteilhafte Führung der Trägerplatte 21 an den Führungsbolzen 20 ist darüber hinaus gewährleistet, dass die Kontakteinrichtung 4 stets optimal zu der Aufnahmeeinrichtung 3 in der Testposition ausgerichtet ist, sodass eine sichere Berührungskontaktierung der gewünschten Kontaktstellen der in der Aufnahmeeinrichtung 3 befindlichen Prüfkarten gewährleistet ist. Die Ausrichtung der Prüfkarten wird durch die jeweils optimal an die Prüfkarten angepasste Tragstruktur 17 sowie die zentrierte Anordnung der Tragstruktur 17 an dem Tragrahmen7 mithilfe der Zentrierbolzen 16 gewährleistet. Sind die Prüfkarten nunmehr elektrisch kontaktiert, kann ein Test der Prüfkarte mithilfe der Prüfvorrichtung 5 durchgeführt werden.

Durch die vorteilhafte Ausbildung der Aufnahmeeinrichtung 3 und der Kontakteinrichtung 4 ist auch ein Austausch der Kontakteinrichtung 4 unabhängig von der Aufnahmeeinrichtung 3 möglich, um beispielsweise die Kontakteinrichtung an unterschiedliche Aufgaben anpassen zu können. Insbesondere ist die Kontakteinrichtung 4 zur Aufnahme eines oder mehrerer unterschiedlicher oder gleicher Kontaktmodule zur Berührungskontaktierung der zumindest einen Prüfkarte oder der mehren Prüfkarten ausgebildet, um eine einfache Anpassung der Kontakteinrichtung 4 zu ermöglichen.

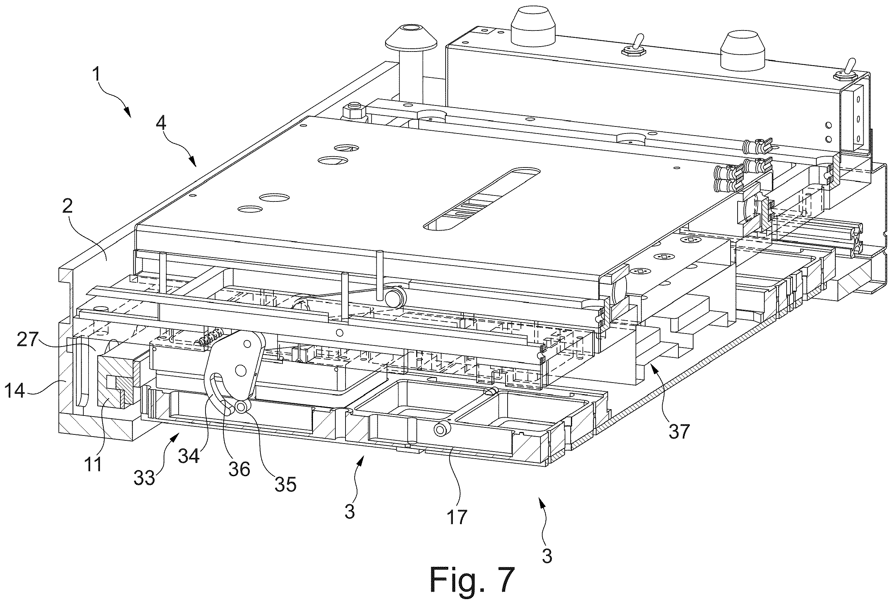

Figur 7 zeigt in einer weiteren Schnittdarstellung eine vorteilhafte Weiterbildung der Testvorrichtung 1, wobei aus den vorhergehenden Ausführungsbeispielen bekannte Elemente mit den gleichen Bezugszeichen versehen sind und insofern auf die oben stehende Beschreibung verwiesen wird. In diesem Ausführungsbeispiel ist außerdem eine auf der Aufnahmeeinrichtung 3 angeordnete Prüfkarte 37 gezeigt.

Gemäß der vorteilhaften Weiterbildung weist die Testvorrichtung 1 im Bereich der Kontakteinrichtung vorteilhafterweise eine Hebeeinrichtung 32 der Stelleinrichtung 19 auf. Die Hebeeinrichtung ist dazu ausgebildet, die Kontakteinrichtung mit der Tragstruktur 17 der Aufnahmeeinrichtung 3 in der Testposition zu koppeln. Dazu weist die Hebeeinrichtung 33 einen oder mehrere verschwenkbare Greifhebel 34 auf, die eine Kulissenführung für einen an der jeweiligen Tragstruktur 17 angeordneten Mitnahmevorsprung 35 aufweisen. Durch Verdrehen des jeweiligen Mitnahmehebels 34 wird der Mitnahmevorsprung 35 in die Kulissenführung 36 des Hebels 34 eingeführt, wobei die Kulissenführung 36 derart ausgebildet ist, dass beim Verschwenken des jeweiligen Hebels 34 der Mitnahmevorsprung 35 nach oben in Richtung der Kontakteinrichtung 4 bewegt wird. Hierdurch kann zusätzlich oder alternativ zu dem vertikalen Verlagern der Kontakteinrichtung 4 insgesamt die Tragstruktur mit den darin befindlichen Prüfkarten in Richtung der Kontakteinrichtung 4 bewegt werden, um die Berührungskontaktierung herzustellen. Ist die Hebeeinrichtung 33 zusätzlich vorgesehen, dient sie insbesondere zur festen Verbindung von Kontakteinrichtung 4 und Tragstruktur 17 während der Durchführung eines Tests.

## Patentansprüche

1. Testvorrichtung (1) für Prüfkarten (37), mit einer Aufnahmeeinrichtung (3) zum Halten zumindest einer zu prüfenden Prüfkarte (37), mit wenigstens einer Kontakteinrichtung (4) zum elektrischen Berührungskontaktieren von elektrisch leitfähigen Kontaktstellen der zumindest einen Prüfkarte (37) in der Aufnahmeeinrichtung (3), wobei die Kontakteinrichtung (4) vertikal oberhalb der Aufnahmeeinrichtung zur Berührungskontaktierung anordenbar ist, und mit einer Stelleinrichtung (19), die dazu ausgebildet ist, die Kontakteinrichtung (4) und die Aufnahmeeinrichtung (3) zur Herstellung der Berührungskontaktierung relativ zueinander zu verlagern, wobei die Aufnahmeeinrichtung (3) durch die Stelleinrichtung (19) von einer vertikal unterhalb der Kontakteinrichtung (4) befindlichen Testposition in eine seitlich von der Kontakteinrichtung (4) beabstandete Be- und Entladeposition und andersherum verlagerbar ist, wobei die Testvorrichtung (1) einen Rahmen (2) aufweist, an welchem die Aufnahmeeinrichtung (3) und die Kontakteinrichtung (4) gelagert sind, wobei die Aufnahmeeinrichtung (3) als horizontal verschiebbare Schublade (6) an dem Rahmen (2) und die Kontakteinrichtung (4) durch die Stelleinrichtung (19) vertikal zwischen einer Berührungskontaktposition und einer Freigabeposition verschiebbar gelagert ist, wobei die Stelleinrichtung (19) zumindest einen ersten ansteuerbaren Aktuator (25) zum Verschieben der Aufnahmeeinrichtung (3) und zumindest einen zweiten ansteuerbaren Aktuator (26) zum Verlagern der Kontakteinrichtung (4) aufweist, **dadurch gekennzeichnet, dass** der zweite Aktuator (26) mit wenigstens einem Schieber (27) gekoppelt ist, der eine Kulissenführung (28), mit einer schräg ausgerichteten Anlauffläche (29) aufweist, die mit einem Mitnahmevorsprung (30) der Kontakteinrichtung (4) zum vertikalen Verlagern der Kontakteinrichtung (4) zusammenwirkt.

2. Testvorrichtung nach Anspruch 1, **dadurch gekennzeichnet, dass** der erste Aktuator (25) und/oder der zweite Aktuator (26) jeweils zumindest einen Elektromotor aufweisen.

3. Testvorrichtung nach einem der vorhergehenden Ansprüche, **dadurch gekennzeichnet, dass** die Kontakteinrichtung (4) zumindest ein Federelement zugeordnet ist, welches die Kontakteinrichtung (4) mit dem Mitnahmevorsprung (30) gegen die Kulissenführung (28) drängt.

4. Testvorrichtung nach einem der vorhergehenden Ansprüche, **dadurch gekennzeichnet, dass** die Kulissenführung (28) an zumindest einem Ende einen Fanghaken (31,32) für den Mitnahmevorsprung (30) aufweist.

5. Testvorrichtung nach einem der vorhergehenden Ansprüche, **dadurch gekennzeichnet, dass** die Kontakteinrichtung (4) durch zumindest drei Führungsbolzen (20) vertikal verschiebbar an dem Rahmen (2) gelagert ist.

6. Testvorrichtung nach einem der vorhergehenden Ansprüche, **dadurch gekennzeichnet, dass** die Aufnahmeeinrichtung (3) eine austauschbare Tragstruktur (17) aufweist, die dazu ausgebildet ist, eine oder mehrere Prüfkarten (37) zu halten.

7. Testvorrichtung nach einem der vorhergehenden Ansprüche, **dadurch gekennzeichnet, dass** der zweite Aktuator (26) eine mit der Tragstruktur (17) koppelbare Hebeeinrichtung (33) aufweist.

8. Testvorrichtung nach einem der vorhergehenden Ansprüche, **dadurch gekennzeichnet, dass** die Aufnahmeeinrichtung (3) einen Tragrahmen (7) aufweist, auf welchem die Tragstruktur (17) auflegbar ist.

9. Testvorrichtung nach einem der vorhergehenden Ansprüche, **dadurch gekennzeichnet, dass** die Tragstruktur (17) wannenförmig ausgebildet ist.

10. Testvorrichtung nach einem der vorhergehenden Ansprüche, **dadurch gekennzeichnet, dass** der Rahmen (2) geschlossene Seitenwände (14) aufweist.

11. Testvorrichtung nach einem der vorhergehenden Ansprüche, **gekennzeichnet durch** eine Prüfeinrichtung (5), die mit der Kontakteinrichtung (4) elektrisch verbunden oder verbindbar ist.

12. Testvorrichtung nach einem der vorhergehenden Ansprüche, **dadurch gekennzeichnet, dass** die Kontakteinrichtung (4) zur Aufnahme eines oder mehrerer unterschiedlicher Kontaktmodule zur Berührungskontaktierung der zumindest einen Prüfkarte (37) ausgebildet ist.

## Claims

1. A test apparatus (1) for test cards (37), comprising a receiving device (3) for holding at least one test card (37) to be tested, comprising at least one contact device (4) for making electrical touch contact with electrically conductive contact points of the at least one test card (37) in the receiving device (3), wherein the contact device (4) can be arranged vertically above the receiving device for the purpose of making touch contact, and comprising an actuating device (19), which is formed to displace the contact device (4) and the receiving device (3) relative to one another for the purpose of establishing the touch contact, wherein the receiving device (3) can be displaced by means of the actuating device (19) from a test position, which is located vertically below the contact device (4), into a loading and unloading position, which is laterally spaced apart from the contact device (4), and the other way round, wherein the test apparatus (1) has a frame (2), to which the receiving device (3) and the contact device (4) are mounted, wherein the receiving device (3) is mounted to the frame (2) as horizontally shiftable drawer (6), and the contact device (4) is mounted in a vertically shiftable manner between a touch contact position and a release position by means of the actuating device (19), wherein the actuating device (19) comprises at least one first controllable actuator (25) for displacing the receiving device (3), and at least one second controllable actuator (26) for displacing the contact device (4), **characterized in that** the second actuator (26) is coupled to at least one slider (27), which comprises a slide guide (28) comprising an obliquely aligned run-on surface (29), which cooperates with an entraining protrusion (30) of the contact device (4) for the purpose of vertically displacing the contact device (4).

2. Test apparatus according to claim 1, **characterized in that** the first actuator (25) and/or the second actuator (26) in each case comprise at least one electric motor.

3. Test apparatus according to one of the preceding claims, **characterized in that** at least one spring element, which forces the contact device (4) with the entraining protrusion (30) against the slide guide (28), is assigned to the contact device (4).

4. Test apparatus according to one of the preceding claims, **characterized in that** the slide guide (28) comprises a catch hook (31, 32) for the entraining protrusion (30) on at least one end.

5. Test apparatus according to one of the preceding claims, **characterized in that** the contact device (4) is mounted in a vertically shiftable manner to the frame (2) by means of at least three guide bolts (20).

6. Test apparatus according to one of the preceding claims, **characterized in that** the receiving device (3) comprises an exchangeable support structure (17), which is formed to hold one or several test cards (37).

7. Test apparatus according to one of the preceding claims, **characterized in that** the second actuator (26) comprises a lifting device (33), which can be coupled to the support structure (17).

8. Test apparatus according to one of the preceding claims, **characterized in that** the receiving device (3) comprises a support frame (7), onto which the support structure (17) can be placed.

9. Test apparatus according to one of the preceding claims, **characterized in that** the support structure (17) is formed in a trough-shaped manner.

10. Test apparatus according to one of the preceding claims, **characterized in that** the frame (2) comprises closed side walls (14).

11. Test apparatus according to one of the preceding claims, **characterized by** a test device (5), which is or can be electrically connected to the contact device (4).

12. Test apparatus according to one of the preceding claims, **characterized in that** the contact device (4) is formed for receiving one or several different contact modules for the purpose of making touch contact with the at least one test card (37).

## Revendications

1. Dispositif de test (1) pour cartes de contrôle (37), avec un dispositif de réception (3) pour maintenir au moins une carte de contrôle (37) à contrôler, avec au moins un dispositif de contact (4) pour établir un contact électrique par toucher avec des points de contact électriquement conducteurs de la au moins une carte de contrôle (37) dans le dispositif de réception (3), dans lequel le dispositif de contact (4) peut être disposé verticalement au-dessus du dispositif de réception pour la mise en contact par toucher, et avec un dispositif de réglage (19) qui est conçu pour déplacer le dispositif de contact (4) et le dispositif de réception (3) l'un par rapport à l'autre pour réaliser la mise en contact par toucher, dans lequel le dispositif de réception (3) peut être déplacé par le dispositif de réglage (19) d'une position de test se trouvant verticalement en dessous du dispositif de contact (4) à une position de chargement et de déchargement espacée latéralement par rapport au dispositif de contact (4) et inversement, dans lequel le dispositif de test (1) présente un cadre (2) sur lequel sont montés le dispositif de réception (3) et le dispositif de contact (4), dans lequel le dispositif de réception (3) est monté sur le cadre (2) sous forme de tiroir (6) déplaçable horizontalement et le dispositif de contact (4) est monté de manière déplaçable verticalement par le dispositif de réglage (19) entre une position de contact par toucher et une position de libération, dans lequel le dispositif de réglage (19) présente au moins un premier actionneur (25) pouvant être commandé pour déplacer le dispositif de réception (3) et au moins un deuxième actionneur (26) pouvant être commandé pour déplacer le dispositif de contact (4), **caractérisé en ce que** le deuxième actionneur (26) est couplé à au moins un coulisseau (27) qui présente un guide de coulisse (28) avec une surface de contact (29) orientée en oblique, qui agit avec une saillie d'entraînement (30) du dispositif de contact (4) pour le déplacement vertical du dispositif de contact (4).

2. Dispositif de test selon la revendication 1, **caractérisé en ce que** le premier actionneur (25) et/ou le deuxième actionneur (26) présentent chacun au moins un moteur électrique.

3. Dispositif de test selon l'une des revendications précédentes, **caractérisé en ce qu'**au moins un élément de ressort qui appuie le dispositif de contact (4) avec la saillie d'entraînement (30) contre le guide de coulisse (28) est associé au dispositif de contact (4).

4. Dispositif de test selon l'une des revendications précédentes, **caractérisé en ce que** le guide de coulisse (28) présente, à au moins une extrémité, un crochet d'accrochage (31, 32) pour la saillie d'entraînement (30).

5. Dispositif de test selon l'une des revendications précédentes, **caractérisé en ce que** le dispositif de contact (4) est monté sur le cadre (2) de manière à pouvoir coulisser verticalement au moyen d'au moins trois boulons de guidage (20).

6. Dispositif de test selon l'une des revendications précédentes, **caractérisé en ce que** le dispositif de réception (3) présente une structure de support (17) interchangeable qui est conçue pour maintenir une ou plusieurs cartes de contrôle (37).

7. Dispositif de test selon l'une des revendications précédentes, **caractérisé en ce que** le deuxième actionneur (26) présente un dispositif de levage (33) pouvant être couplé à la structure de support (17).

8. Dispositif de test selon l'une des revendications précédentes, **caractérisé en ce que** le dispositif de réception (3) présente un cadre de support (7) sur lequel la structure de support (17) peut être posée.

9. Dispositif de test selon l'une des revendications précédentes, **caractérisé en ce que** la structure de support (17) est en forme de cuvette.

10. Dispositif de test selon l'une des revendications précédentes, **caractérisé en ce que** le cadre (2) présente des parois latérales fermées (14).

11. Dispositif de test selon l'une des revendications précédentes, **caractérisé par** un dispositif de contrôle (5) qui est relié ou peut être relié électriquement au dispositif de contact (4).

12. Dispositif de test selon l'une des revendications précédentes, **caractérisé en ce que** le dispositif de contact (4) est conçu pour recevoir un ou plusieurs modules de contact différents pour la mise en contact par toucher de l'au moins une carte de contrôle (37).
